# EUROPEAN PATENT APPLICATION

(11) **EP 2 120 509 A1**
(43) Date of publication of application: **18.11.2009**
(21) Application number: 08710974.0
(22) Date of filing: 08.02.2008
(51) Int. Cl.: H05B 33/02, G02B 3/00, G02F 1/137, H01L 51/50, H05B 33/10

(54) **ORGANIC EL ELEMENT AND METHOD FOR MANUFACTURING THE ORGANIC EL ELEMENT AND ORGANIC EL ELEMENT EVALUATING METHOD**

(30) Priority: 09.02.2007 JP 2007030213
(71) Applicant: Sumitomo Chemical Company, Limited, Tokyo 104-8260 (JP); Tokyo Institute of Technology, Tokyo 152-8550 (JP)
(72) Inventor: IKEDA, Tomiki, Yokohama-shi Kanagawa 226-8503 (JP); KINOSHITA, Motoi, Yokohama-shi Kanagawa 226-8503 (JP); KOBAYASHI, Tomohiro, Yokohama-shi Kanagawa 226-8503 (JP); YAMAMOTO, Kyoko, Tsukuba-shi Ibaraki 305-0045 (JP); TANAKA, Shin-ya, Tsukuba-shi Ibaraki 305-0047 (JP); SAKANO, Fumihiro, Tsukuba-shi Ibaraki 305-0005 (JP)
(74) Representative: Duckworth, Timothy John
(86) International application number: PCT/JP2008/052095
(87) International publication number: WO 2008/096840

(57) **Abstract**

Provided are an organic EL device having improved conductivity of an anode compared with conventional organic EL devices, and a method for manufacturing such organic EL device. The organic EL device is provided with a layer-like optical element (40), which at least contains a liquid crystal material and a dye, has a refractive index distribution based on orientation of liquid crystal molecules constituting the liquid crystal material, and has the refractive index distribution fixed; a substrate (11) which can transmit visible light; a light emitting layer (60) composed of an organic EL material; a cathode (70); and an anode (50). Each of the cathode (70) and the anode (60) is formed layer-like. The organic EL device is further provided with an alignment film (12), and the alignment film (12) and the optical element (40) are in contact with each other.

## Description

### Technical Field

The present invention relates to an organic EL device, its manufacturing method, and an organic EL device evaluating method.

### Background Art

An organic electroluminescence element (which may hereinafter be referred to as organic EL device) is a light emitting device. The structure of an organic EL device can be expressed as substrate/anode/light emitting layer/cathode (in which each slash mark (/) indicates that the respective layers are adjacent to each other). In such an organic EL device, it is desired to enhance its light emitting efficiency, and attempts for taking out light emitted from the light emitting layer in the above-described structure efficiently to the outside of the EL device, that is, attempts for enhancing the outcoupling efficiency have been made. An example of the organic EL devices embodying such an attempt, in which a semispherical microlens is disposed at the interface of the substrate and the anode, is disclosed in Patent Document 1.

Patent Document 1: JP-A-2006-23683

### Disclosure of the Invention

### Problem to be Solved by the Invention

The organic EL devices described above, however, are still unsatisfactory in conductivity at the anode and in light emitting efficiency of the EL device, due to non-uniform thickness of the anode disposed adjacently to a semispherical microlens. The present invention is envisioned to provide an organic EL device which is enhanced in its light emitting efficiency in comparison to the conventional organic EL devices, and a method for manufacturing such an organic EL device.

### Means for Solving the Problem

Concentrated studies by the present inventors for solving the above problem have led to the realization of the present invention.
The present invention is embodied as described in <1> to <8> below.
<1> An organic EL device comprising:
   a layered optical element which contains at least a liquid crystal material and a dye and has a refractive index distribution based on orientation of the liquid crystal molecules constituting the liquid crystal material, wherein said refractive index distribution is fixed;
   a substrate which can transmit visible light;
   a light emitting layer comprising an organic EL material;
   a cathode; and
   an anode.
<2> An organic EL device described above in which both of the cathode and the anode are layered.
<3> An organic EL device described above which further comprises an alignment film which is contacted with the optical element.
<4> An organic EL device described in <3> above in which the layered anode is contacted with the optical element.
<5> A method for producing an organic EL device comprising the following steps (A1), (A2), (A3) and (A4) in this order:
   (A1) using two substrates each having an alignment film (wherein at least one of the substrates is capable of transmitting visible light), arranging the two substrates so that their respective alignment films face each other, disposing a polymerizable mixture containing a liquid crystal material and a dye between the opposing alignment films, irradiating the polymerizable mixture with light to orient a liquid crystal molecule in the liquid crystal material, and further polymerizing said polymerizable mixture for fixing it to obtain a liquid crystal molecule-fixed layer (optical element);
   (A2) separating one of the substrates having an alignment film to obtain a substrate having the optical element and the alignment film (wherein said substrate is one capable of transmitting visible light);
   (A3) forming a layered anode on an optical element side of the substrate having the optical element and the alignment film; and
   (A4) forming a light emitting layer comprising an organic EL material and a layered cathode in this order on a layered anode side of the substrate.
<6> An organic EL device described in <3> wherein the layered anode is contacted with the substrate capable of transmitting visible light.
<7> A method for producing an organic EL device comprising the following steps (B1), (B2), (B3) and (B4) in this order:
   (B1) using two substrates each having an alignment film (wherein at least one of the substrates is capable of transmitting visible light), arranging the two substrates so that their respective alignment films face each other, disposing a polymerizable mixture containing a liquid crystal material and a dye between the opposing alignment films, irradiating the polymerizable mixture with light to orient a liquid crystal molecule in the liquid crystal material, and further polymerizing said polymerizable mixture for fixing it to obtain a liquid crystal molecule-fixed layer (optical element);
   (B2) separating one of the substrates having an alignment film to obtain a substrate having the optical element and the alignment film (wherein said substrate is one capable of transmitting visible light);
   (B3) forming a layered anode on a bare side of the substrate having the optical element and the alignment film; and
   (B4) forming a light emitting layer comprising an organic EL material and a layered cathode in this order on a layered anode of the substrate.
<8> A method for evaluating an organic EL device comprising the step of: using a ray tracing simulation in designing a structure of the organic EL device described in <1>, <2>, <3>, <4> or <6>.

### Advantages of the Invention

In accordance with the present invention, it is possible to provide an organic EL device which is capable of enhancing conductivity at the anode in comparison to the conventional organic EL devices. The organic EL device of the present invention shows high light emitting efficiency and is of great industrial use.

### Best Mode for Carrying out the Invention

The organic EL device according to the present invention is characterized by comprising a layered optical element which at least contains a liquid crystal material and a dye and has a refractive index distribution based on orientation of liquid crystal molecules constituting the liquid crystal material, the said refractive index distribution being fixed; a substrate which can transmit visible light; a light emitting layer composed of an organic EL material; a cathode; and an anode.

In the present invention, both cathode and anode are layered in the ordinary mode of carrying out the invention. The cathode and the anode are assigned with the role of flowing an electric current to the light emitting layer, and if this assignment can be fulfilled, they may not necessarily be layered.

The organic EL device is further provided with an alignment film, and it is preferable for production facility that this alignment film is positioned contiguously to the optical element. Here, the term "alignment film" is used to refer to a film which is capable of inducing orientation of liquid crystal molecules.

The optical element constituting an essential part of the organic EL device of the present invention is here described in detail. In the following descriptions, all "parts" and "%" indicating the amount ratios are by mass unless otherwise noted.

### (Optical element)

In the present invention, the optical element contains at least a liquid crystal material and a dye, and has a refractive index distribution based on orientation of liquid crystal molecules constituting the liquid crystal material, with the said refractive index distribution being fixed. This optical element can perform the optical functions such as light refraction and convergence of lens, and its both sides are planar, creating a layered configuration.

### (Dye)

Regarding orientation of liquid crystal molecules constituting the liquid crystal material, usually the liquid crystal molecules are oriented either horizontally (homogeneous alignment) or vertically (homeotropic alignment) to the alignment film depending on the type of the alignment film used. It is remarkable that in the optical element of the present invention, a dye is contained in addition to a liquid crystal material. The dye molecules in this dye are oriented on exposure to light such as laser light (polarized light), and the direction of orientation of the dye molecules varies according to the intensity of irradiation light. Since the liquid crystal molecules around the dye molecules are oriented in accordance with the change of orientation of the liquid crystal molecules, the optical element is allowed to possess a refractive index distribution based on orientation of liquid crystal molecules. Also, since the intensity of irradiation light varies continuously, the above refractive index distribution changes continuously, too. For instance, in a system containing a liquid crystal material and a dye, if the pattern of orientation of liquid crystal molecules constituting the liquid crystal material is homeotropic, the dye molecules are changed in their direction of orientation according to the irradiation of light such as laser light (polarized light), and the liquid crystal molecules around the dye molecules are oriented in accordance with the change of orientation of dye molecules. This illustrates that at a part where irradiation light is relatively strong, the liquid crystal molecules are converted from homeotropic to homogeneous orientation, while at a part where irradiation light is relatively weak, the above conversion is restricted. Consequently, there is provided an optical element based on a refractive index distribution by the said irradiation with light. As far as orientation of dye molecules is possible by the above-described light irradiation, the type of the dyes usable is not specifically defined, but the following may be cited as preferred examples of dye.

### (Examples of suitable dyes)

Terthiophenic liquid crystalline conjugate dyes. Dye molecules in such dyes include, for instance, those represented by the following formulae:

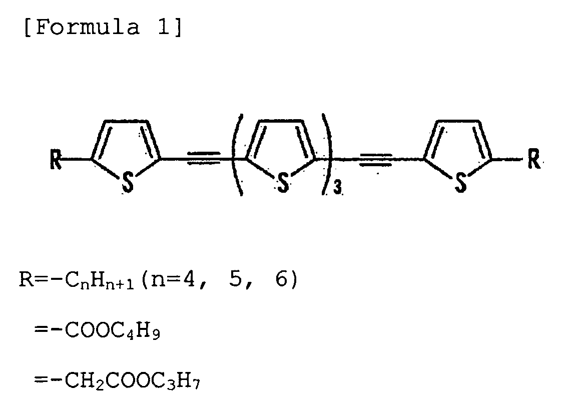

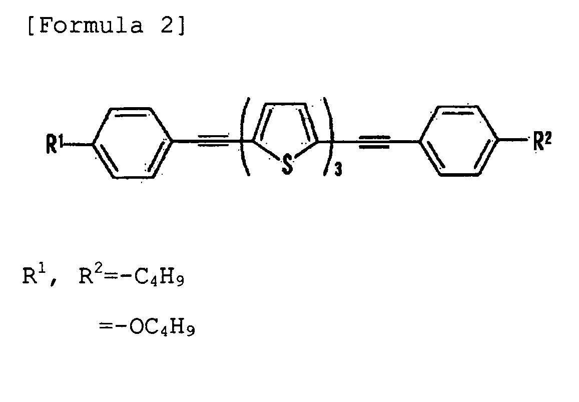

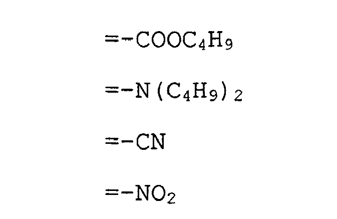

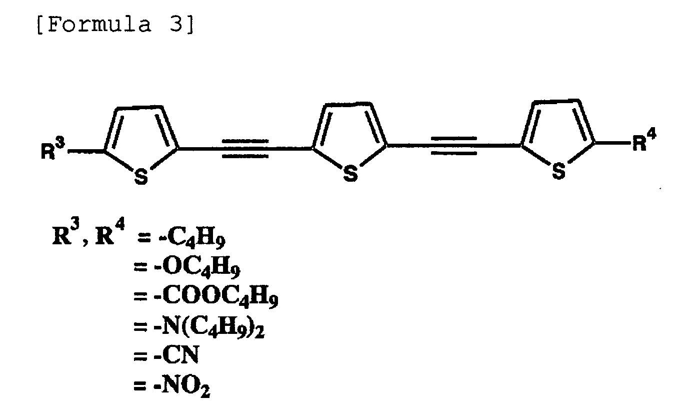

### (Liquid crystal material)

The type of liquid crystal materials usable in this invention is not subject to any specific restrictions as far as the liquid crystal molecules around the dye molecules can be oriented according to orientation of dye molecules by the above-described light irradiation, but the following materials (indicated by the liquid crystal molecules constituting the liquid crystal materials) can be cited as preferred examples.

### (Examples of preferred liquid crystal molecules)

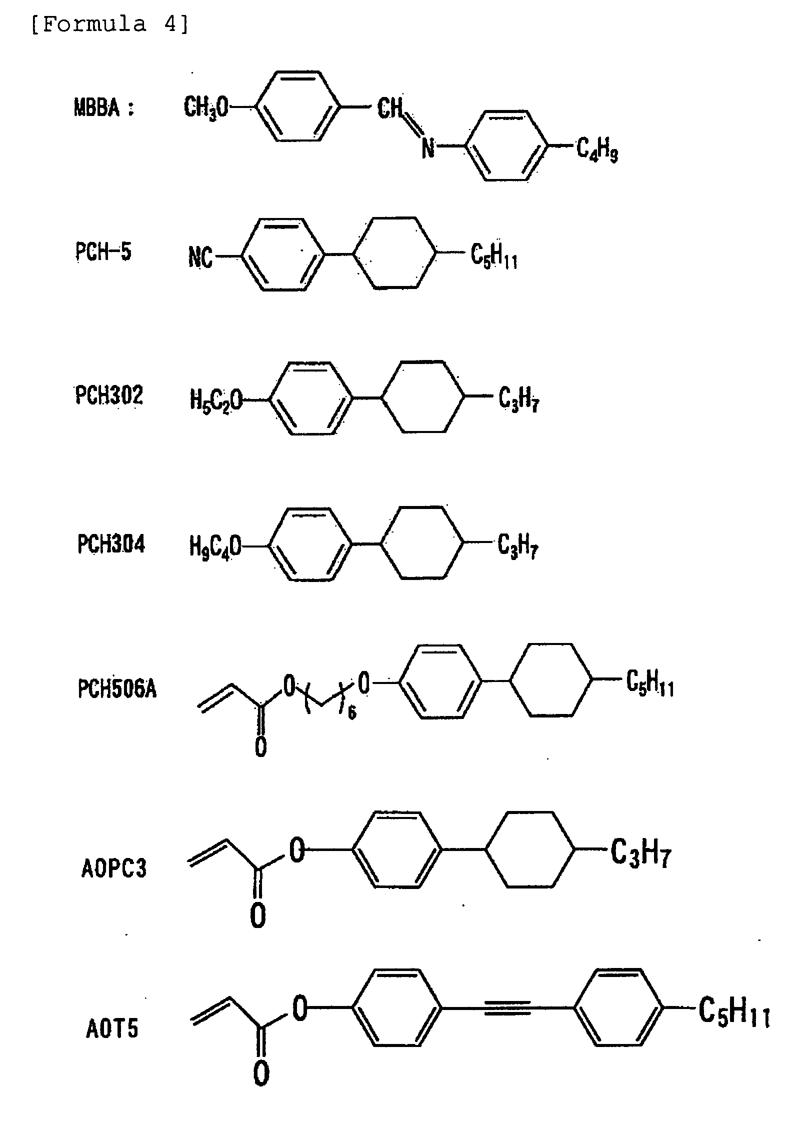

### (Fixation of refractive index distribution)

The above optical element has its refractive index distribution fixed. This fixation can be effected by means of polymerization. In this case, the system before fixation needs to have polymerizability, but the purpose can be met by making the dye molecules and/or liquid crystal molecules polymerizable. It is also possible to use other polymerizable materials such as mentioned below. The pattern of polymerization may be typically photopolymerization or thermal polymerization, but photopolymerization is preferred as it can effect fixation while maintaining the intended form of orientation of liquid crystal molecules. In the case of thermal polymerization, there may be the occasions where the liquid crystal phase is changed during heating to make it unable to obtain the desired form of orientation. In carrying out photopolymerization, the system before fixation is irradiated with light to fix the oriented liquid crystal molecules. When the system before fixation is irradiated with light, usually the speed at which the refractive index distribution based on orientation of liquid crystal molecules is formed is faster than the speed at which the system is fixed. As the light source for irradiation in photopolymerization, those emitting visible light and/or near infrared light can be used, the typical examples thereof being metal halide lamp, incandescent electric lamp, halogen lamp, xenon lamp and high pressure mercury lamp.

### (Polymerizable materials)

No specific restrictions are imposed on the type of polymerizable materials usable in this invention. It is essential that the polymerizable materials have a polymerizable group, and it is preferable that the system before fixation has liquid crystallinity. Examples of such polymerizable materials are the compounds having a vinyl group, for example, those cited below.

(Examples of preferred polymerizable materials)

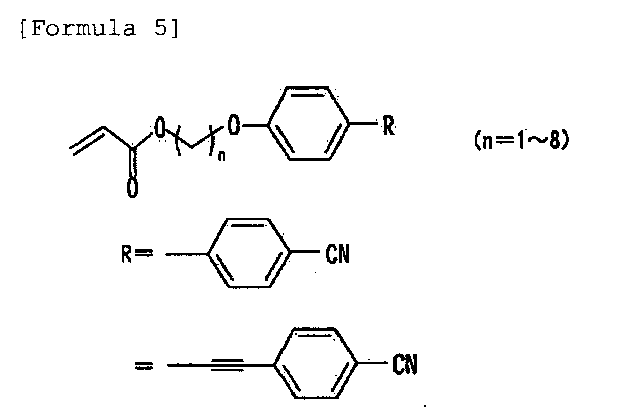

### (Polymerizable mixture)

The polymerizable mixture referred to in the present invention is synonymous with the system before fixation (viz. the system before irradiation with light). The polymerizable mixture in the present invention is preferably of the following formulation:
Liquid crystal material: 100 parts (basis)
Dye: from 0.0001 to 10 parts (more preferably from 0.001 to 1 part)
Polymerizable material (when used): from 1 to 100 parts (more preferably from 5 to 30 parts)

### (Additives)

The polymerizable mixture may contain where necessary various additives such as, for instance, polymerization initiator, typically photopolymerization initiator. Any type of polymerization initiator which is capable of advancing the above-described polymerization reaction by irradiation with light such as ultraviolet light can be used. Examples of such polymerization initiator are acetophenone compounds, benzophenone compounds, benzoin compounds, benzoic ether compounds, acylphosphine oxide compounds, and thioxanthone compounds. The commercially available products of these compounds include, for instance, "IRGACURE 184", "IRGACURE 369", "IRGACURE 651", "IRGACURE 907", "IRGACURE 819", "IRGACURE 2959" and "DAROCURE 1173" (all being the products by Ciba Specialty Chemicals Co., Ltd.), "KAYACURE BP" and "KAYACURE DETX-S" (both produced by Nippon Kayaku Co., Ltd.), "ESACURE KIP 150" (produced by Lamberti Ltd.), "S-121" (produced by Shinko Giken Co., Ltd.), "SEIKUOR (produced by Seiko Chemical Co., Ltd.), and "SOLVASLON BIPE" and "SOLVASLON BIBE" (both produced by Kurogane Kasei Co., Ltd. These photopolymerization inititators may be used singly or in the form of a mixture of any two or more of them.

### (Preferred polymerizable mixture)

The polymerizable mixture of the present invention preferably has the following properties. It is essential that the polymerizable mixture of the present invention shows liquid crystal characteristics such as nematic liquid crystal phase when irradiated with light. The broader the mesomorphic temperature range, the more preferable. The composition is preferably capable of developing a liquid crystal phase at close to room temperature (20°C) for ease of treatment. (The type of the liquid crystal phase is not specifically defined.) More specifically, the composition is preferably one which can develop the liquid crystal phase in a temperature range of around from -50°C to +50°C (more preferably around from -20°C to +40°C). For identification of liquid crystal and its phase, refer to "Handbook of Liquid Crystal," pp. 1-448, edited by Handbook of Liquid Crystal Editorial Board (Maruzen, Japan, 2000).

### (Characteristics of preferred optical element)

The optical element of the present invention preferably has the following characteristics (1) to (3).

### (1) Total light transmittance

Total light transmittance of the optical element is preferably 70% or higher, more preferably 80% or higher.

### (2) Surface flatness

Both sides of the optical element are planar, and center line average roughness (Ra) of its surface is preferably 100 nm or less, more preferably 50 nm or less.

### (3) Thickness

Thickness of the optical element is preferably 5 mm or less, more preferably 3 mm or less, even more preferably 1 mm or less.

The light emitting layer constituting part of the organic EL device of the present invention is here described in detail. The present invention embraces the light emitting layers of the following structures.

### (Examples of light emitting layer)

a) Organic light emitting layer
b) Hole transport layer/organic light emitting layer
c) Organic light emitting layer/electron transport layer
d) Hole transport layer/organic light emitting layer/electron transport layer
e) Charge injection layer/organic light emitting layer
f) Organic light emitting layer/charge injection layer
g) Charge injection layer/organic light emitting layer/charge injection layer
h) Charge injection layer/hole transport layer/organic light emitting layer
i) Hole transport layer/organic light emitting layer/charge injection layer
j) Charge injection layer/hole transport layer/organic light emitting layer/charge injection layer
k) Charge injection layer/organic light emitting layer/charge transport layer
l) Organic light emitting layer/electron transport layer/charge injection layer
m) Charge injection layer/organic light emitting layer/electron transport layer/charge injection layer
n) Charge injection layer/hole transport layer/organic light emitting layer/charge transport layer
o) Hole transport layer/organic light emitting layer/electron transport layer/charge injection layer
p) Charge injection layer/hole transport layer/organic light emitting layer/electron transport layer/charge injection layer
In the above structural depictions, each slash mark (/) indicates that the layers on both sides of the slash are adjacent (contiguous) to each other. Also, in the present invention, the "organic EL materials" designate the materials constituting the above-described layers. The known materials can be used for the respective layers. For more detail on these materials, reference is made to S. Tokitou, C. Adachi and H. Murata: "Organic EL Displays" (pub. by Ohm Ltd.; 1st ed. 1st printing, 2004); T. Ohnishi and A. Koyama: "Polymeric EL Materials" (pub. by Kyoritsu Pub. Co.; 1st ed. 1st printing, 2004), and other related literatures. Thickness of the above layers may be properly set, but it is generally from 1 to 300 nm, preferably around from 5 to 100 nm.

### (Examples of organic light emitting layer)

The material constituting the organic light emitting layer, which is an indispensable component of the above compositions, may be either a small molecular compound or a polymer compound. Examples of the small molecular compounds usable as such a material include naphthalene derivatives, anthracene and its derivatives, perillene and its derivatives, dyes such as polymethine dye, xanthene dye, cumalin dye and cyanine dye, metal complexes of 8-hydroxyquinoline and its derivatives, aromatic amines, tetraphenylcyclopentadiene and its derivatives, and tetraphenylbutadiene and its derivatives. Exemplary of the polymer compounds are polyfluorene, its derivatives and copolymers thereof, polyarylene, its derivatives and copolymers thereof, polyarylenevinylene, its derivatives and copolymers thereof, and aromatic amines, their derivatives and (co)polymers thereof. It is also possible to use the materials which are capable of triplet light emission, such as Ir(ppy)₃ and Btp₂Ir(acac) using iridium as base metal, PtOEP using platinum as base metal, and Eu(TTA)₃phen using europium as base metal.

### (Anode/light emitting layer/cathode structure)

In the present invention, when both anode and cathode are layered, the anode/light emitting layer/cathode structure is embodied as follows:
a) Anode/organic light emitting layer/cathode
b) Anode/hole transport layer/organic light emitting layer/cathode
c) Anode/organic light emitting layer/electron transport layer/cathode
d) Anode/hole transport layer/organic light emitting layer/electron transport layer/cathode
e) Anode/charge injection layer/organic light emitting layer/cathode
f) Anode/organic light emitting layer/charge injection layer/cathode
g) Anode/charge injection layer/organic light emitting layer/charge injection layer/cathode
h) Anode/charge injection layer/hole transport layer/organic light emitting layer/cathode
i) Anode/hole transport layer/organic light emitting layer/charge injection layer/cathode
j) Anode/charge injection layer/hole transport layer/organic light emitting layer/charge injection layer/cathode
k) Anode/charge injection layer/organic light emitting layer/charge transport layer/cathode
l) Anode/organic light emitting layer/electron transport layer/charge injection layer/cathode
m) Anode/charge injection layer/organic light emitting layer/charge injection layer/cathode
n) Anode/charge injection layer/hole transport layer/organic light emitting layer/charge transport layer/cathode
o) Anode/hole transport layer/organic light emitting layer/electron transport layer/charge injection layer/cathode
p) Anode/charge injection layer/hole transport layer/organic light emitting layer/electron transport layer/charge injection layer/cathode
Each slash mark (/) in the above structural formulations indicates that the layers on both sides of the slash mark are adjacent to each other. The known materials can be used for the anode and the cathode. When a charge injection layer is incorporated, an insulating layer having a thickness of approximately 10 nm or less and made of a metal fluoride, a metal oxide or an organic insulating material may be provided at the interface of anode/charge injection layer or charge injection layer/cathode for the purpose of facilitating injection of charge. In the present invention, such an insulating layer is regarded as part of the charge injection layer.

Of the above-shown structures a) to p), those of g), j), m) and p) are preferred in view of higher light emitting efficiency.

### (Anode)

In the present invention, the layered anode needs to be transparent or translucent. Conductive metal oxide film, translucent thin metal film and the like can be used as the anode. Examples of the anode materials usable in the present invention include indium oxide, zinc oxide, tin oxide, indium tin oxide (ITO), indium zinc oxide, gold, platinum, silver, copper and the like. Of these materials, ITO, indium zinc oxide and tin oxide are preferred. Organic transparent conductive films made of polyaniline or its derivatives, polythiophene or its derivatives, or the like, are also usable as the layered anode of the present invention. Thickness of the layered anode may be properly decided in consideration of light transmission properties and conductivity of the material used, but it is usually around from 10 nm to 10 µm, preferably from 20 nm to 1 µm, more preferably from 50 nm to 500 nm. The known methods such as vacuum deposition, sputtering, ion plating and plating can be used for forming the anode.

### (Cathode)

Metals such as barium, calcium, gold, magnesium and magnesium/silver alloy can be used as the material of the layered cathode of the present invention. The cathode may be of a multi-layered structure formed by depositing aluminum, silver, chromium or the like on the above metals. The cathode thickness may be properly set but is preferably around 3 to 50 nm.

### (Substrate)

It is essential to use a material capable of transmitting visible light as the substrate in the present invention, the examples of such a material being glass, plastic, polymer film and silicon. Substrate thickness differs depending on the purpose of use (display, illumination, flexible display, etc.) of the produced organic EL device, but it is usually around 50 µm to 2 mm.

Regarding the method for producing the organic EL device according to the present invention, here is illustrated a method for producing an organic EL device of the type having an alignment film in which this alignment film is disposed contiguously to an optical element which, on its other side, is contiguous to a layered anode.

The above organic EL device can be produced by conducting the following steps (A1), (A2), (A3) and (A4) in this order:
(A1) using two substrates each having an alignment film (wherein at least one of the substrates is capable of transmitting visible light), arranging the two substrates so that their respective alignment films face each other, disposing a polymerizable mixture containing a liquid crystal material and a dye between the opposing alignment films, irradiating the polymerizable mixture with light to orient a liquid crystal molecule in the liquid crystal material, and further polymerizing said polymerizable mixture for fixing it to obtain a liquid crystal molecule-fixed layer (optical element);
(A2) separating one of the substrates having an alignment film to obtain a substrate having the optical element and the alignment film (wherein said substrate is one capable of transmitting visible light);
(A3) forming a layered anode on an optical element side of the substrate having the optical element and the alignment film; and
(A4) forming a light emitting layer comprising an organic EL material and a layered cathode in this order on a layered anode side of the substrate.

With reference to the substrates having an alignment film used in the step (A1), the alignment film is a film capable of inducing orientation of the liquid crystal molecules and is placed on each substrate. There are used two substrates each having such an alignment film, with at least one of the substrates being of the type capable of transmitting visible light. Also, in the present invention, both of the alignment films are the ones which are capable of inducing homeotropic alignment of the liquid crystal molecules (the liquid crystal molecules are oriented in the direction vertical to the alignment film; this film may hereinafter be referred to as homeotropic alignment film), and which can transmit visible light.

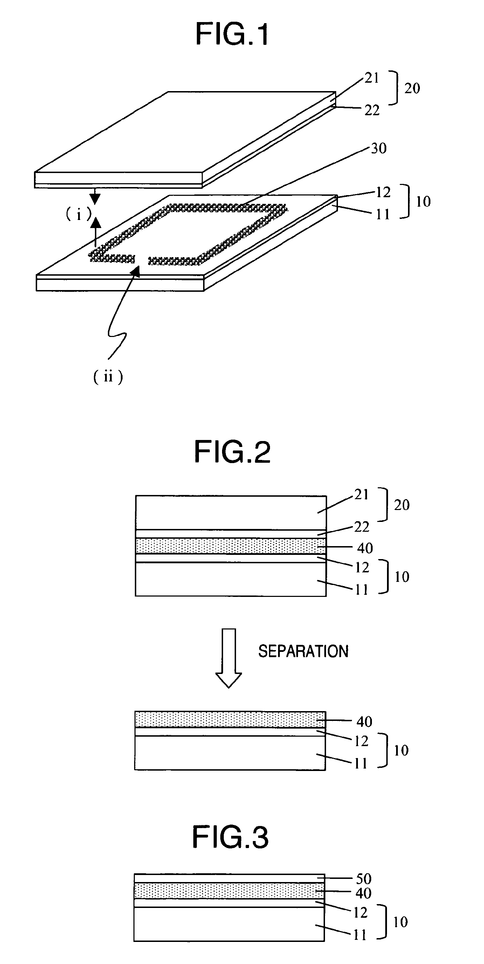

In the step (A1), as mentioned above, there are used two substrates each having an alignment film and arranged so that their respective alignment films will face each other, and a polymerizable mixture containing a liquid crystal material and a dye is sandwiched between the opposing alignment films. The methods (I) and (II) described below exemplify the way for providing such a sandwiched arrangement.
(I) The two substrates each having an alignment film are placed so that their respective alignment films will face each other, and bonded together with the intervention of a spacer such as beads controlled in particle size to constitute a cell ((i) in Fig. 1), and a polymerizable mixture is injected into this cell under normal pressure or in vacuo ((ii) in Fig. 1). The spacer may be contained in a sealer. Also, the spacer may be arranged as a frame on the alignment film. Fig. 1 is a schematic illustration of this arrangement.
(II) The surface of the alignment film of one of the substrates having an alignment film is coated with a polymerizable mixture, and the alignment film of the other substrate is bonded on the surface of the coating of the polymerizable mixture. In this case, in order to uniformly control thickness of the obtained liquid crystal molecules-fixed layer (optical element), the beads with controlled particle size or such may be used a spacer at the time of bonding or coating with a polymerizable mixture. In use of such a spacer, it may be, for instance, scattered on one of the alignment films before coating with a polymerizable mixture or may be mixed with a polymerizable mixture.
In either of the above methods (I) and (II), various types of particles such as glass fiber, silica particles and styrene particles can be used as spacer. Usually such particles with a size of about from 1 to 10 µm are used at a rate of from 100 to 200 pieces per mm².

As explained above, a polymerizable mixture containing a liquid crystal material and a dye is interposed between the two opposing alignment films and the liquid crystal molecules in the polymerizable mixture are oriented to show homeotropic alignment.
The polymerizable mixture is irradiated with light such as laser light (polarized light) to let the polymerizable mixture have a refractive index distribution, and the composition is further polymerized for fixing the liquid crystal molecules to obtain a liquid crystal molecules-fixed layer (optical element). Such polymerization of the polymerizable mixture for fixation can be accomplished by irradiating the composition with light from a lamp such as metal halide lamp, glow lamp, halogen lamp, xenon lamp, high pressure mercury lamp or the like.

In the step (A2), one of the substrates having an alignment film is separated to obtain a substrate having an optical element and an alignment film (this film being one capable of transmitting visible light). This step of operation is illustrated schematically in Fig. 2. In case no alignment film is used in the manufacture of the organic EL device of the present invention, initially an optical element alone is obtained, and it is placed on, for instance, a substance which can pass visible light.

In the step (A3), a layered anode is formed on the optical element side of the substrate having the said optical element and an alignment film. Fig. 3 is a schematic illustration of this step. In the present invention, the optical element is planar on its both sides, so that when a layered anode is formed on the optical element side, thickness of the anode becomes uniform, making it possible to raise conductivity of the anode. When ITO is used as the anode material, usually a layered anode is formed by sputtering.

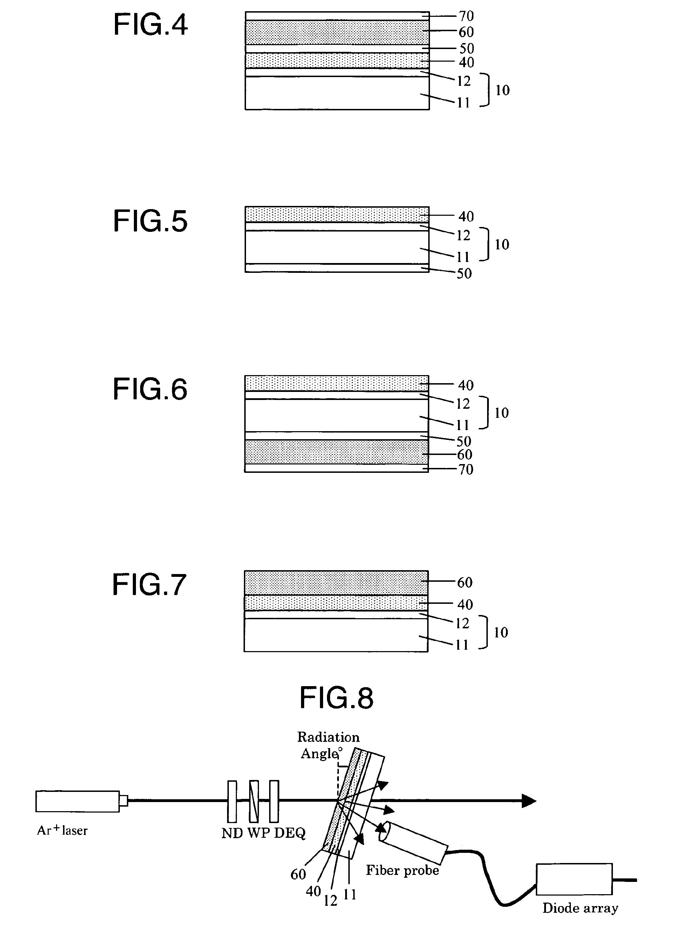

In the step (A4), a light emitting layer composed of an organic EL material and a layered cathode are formed in this order on the layered anode. This step is schematically illustrated in Fig. 4. For forming the light emitting layer, the above-described layers are used, and the materials composing these layers are shaped by a conventional method such as vacuum deposition, cluster deposition, electron beam deposition, coating and printing. For forming a layered cathode, the above-mentioned materials are shaped by a suitable method such as vacuum deposition, sputtering, or a lamination method in which a thin metallic film is heat-press bonded. In forming these light emitting layer and layered cathode, an appropriate shaping method is selected by taking into consideration the properties of the materials used.

Pertaining to the method for producing the optical EL device of the present invention, here is described a method for producing an organic EL device of a structure having an alignment film in which said alignment film is contacted with (disposed contiguously to) an optical element and a layered anode is contacted with (positioned contiguously to) a substrate which can transmit visible light.

The above organic EL device can be produced by carrying out a process comprising the following steps (B1), (B2), (B3) and (B4) which are conducted in this order:
(B1) using two substrates each having an alignment film (wherein at least one of the substrates is capable of transmitting visible light), arranging the two substrates so that their respective alignment films face each other, disposing a polymerizable mixture containing a liquid crystal material and a dye between the opposing alignment films, irradiating the polymerizable mixture with light to orient a liquid crystal molecule in the liquid crystal material, and further polymerizing said polymerizable mixture for fixing it to obtain a liquid crystal molecule-fixed layer (optical element);
(B2) separating one of the substrates having an alignment film to obtain a substrate having the optical element and the alignment film (wherein said substrate is one capable of transmitting visible light);
(B3) forming a layered anode on a bare side of the substrate having the optical element and the alignment film; and
(B4) forming a light emitting layer comprising an organic EL material and a layered cathode in this order on a layered anode of the substrate.

The step (B1) and the step (B2) are identical with the step (A1) and the step (A2), respectively. In the step (B3), a layered anode is formed on the substrate side of the substrate having an optical element and an alignment film obtained in the step (B2). This procedure is schematically illustrated in Fig. 5. When ITO is used as the anode material, usually the layered anode is formed by sputtering.

In the step (B4), a light emitting layer comprising of an organic EL material and a layered cathode are formed in this order on the side of the layered anode. Fig. 6 is a schematic illustration of this step. The step (B4) is otherwise the same as the step (A4).

In case an anode material such as ITO is formed on the side opposite from the alignment film of the visible light transmittable substrate in the step (B1), the step (B3) may be omitted.

In the steps (A4) and (B4), after forming a cathode, usually the unit is sealed by a sealer to obtain an organic EL device. In making such sealing, it needs to make arrangement so that a part of both anode and cathode can be electrically connected to an outside power source. The organic EL device emits light when both anode and cathode are electrically connected to the outside power source.

Ray tracing simulation is very useful as a means for more specifically designing and evaluating the structure of the organic EL device of the present invention. Ray tracing simulation is a sort of Monte-Carlo probability simulation based on geometrical optics, according to which the shape, refractive index and interfacial reflection characteristics of the component members of a model serving as the subject of simulation are set, and transmission and reflection of each of the rays of light generated in a probabilistically sufficient large number are tracked, with the above operation being repeated until the obtained results converge sufficiently. By using this ray tracing simulation, the various factors in designing the structure of the organic EL device of the present invention, such as thickness of the component members (such as optical element, substrate and anode) and refractive index distribution in the optical element can be optimized, making it possible to design and evaluate an organic EL device which is capable of enhancing outcoupling efficiency as well as light emitting efficiency. By making use of the results obtained from this evaluation method of the present invention, it is possible to produce an organic EL device capable of realizing an enhanced light emitting efficiency while properly designing the production conditions such as thickness of the component layers, intensity of irradiation by laser light (polarized light), size of laser irradiation spot, and site of laser irradiation.

The present invention is described in further detail below with reference to its embodiments.

### Examples

### Production Example 1

### (Production of optical element)

As the liquid crystal molecules, those having an acrylate group are preferred. Using AOPC3 and AOT5 as such liquid crystal molecules, there was prepared one mole of a liquid crystal material with an AOPC3:AOT5 molar ratio of 0.54:0.46. To this preparation were added a liquid crystallizable oligothiophene derivative (a compound represented by the above-shown formula [1] wherein R = -CₙH_{n+1,} n = 5) as a dye in an amount of 0.1% by mole and IRGACURE 184 as a photopolymerization initiator in an amount of 1% by mole, both based on the said liquid crystal material, to obtain a polymerizable mixture. Using lecithin as the alignment film (an alignment film inducing homeotropic alignment), a cell was constructed (both substrates being glass substrates capable of transmitting visible light) as shown in Fig. 1. This polymerizable mixture was sealed at an isotropic phase temperature (the polymerizable mixture being in a liquid state) and then cooled down slowly to room temperature to prepare a sample having the liquid crystal molecules oriented to have homeotropic alignment. The sample was irradiated with 364 nm Ar ion laser at 2.1 W/cm² to induce a refractive index distribution (this also let advance fixation of the polymerizable mixture at the laser irradiated spot). This refractive index distribution inducing operation was repeated while shifting the laser irradiation spot, and lastly one side of the sample was irradiated with 366 nm bright line of a high pressure mercury lamp at a light intensity of 5 W/cm² for 10 minutes to cause photopolymerization of the composition to thereby fix the whole of the composition to obtain an optical element 1. Thereafter, one of the substrates having an alignment film was separated to obtain a substrate having the optical element 1 and an alignment film (see FIG. 2). The surface of the optical element 1 was flat.

### Example 1

A coating film of an ITO material was formed by sputtering on the optical element 1 side of the substrate having the optical element 1 and an alignment film obtained in Production Example 1 to make a layered anode (transparent electrode) with high conductivity. Further, a light emitting layer and a layered cathode were formed on this anode (see Fig. 4) to obtain an organic EL device with high outcoupling efficiency and high light emitting efficiency.

### Example 2

A coating film of an ITO material was formed by sputtering on the glass substrate side of the substrate having the optical element 1 and an alignment film obtained in Production Example 1 to make a layered anode (transparent electrode) with high conductivity. Further, a light emitting layer and a layered cathode were formed on this anode (see Fig. 6) to obtain an organic EL device with high outcoupling efficiency and high light emitting efficiency.

### Example 3

### (Production of optical element)

As the liquid crystal molecules, those having an acrylate group are preferred. Using AOPC3, AOT5 and PCH-5 as such liquid crystal molecules, there was prepared one mole of a liquid crystal material with an AOPC3:AOT5:PCH-5 molar ratio of 0.43:0.37:0.20. To this preparation were added a liquid crystallizable oligothiophene derivative (a compound represented by the above-shown formula [3] wherein R₃ = -CₙHₙ₊₁, R₄ = -CₙH_{n+1,} n = 4) as a dye in an amount of 0.1% by mole and IRGACURE 184 as a photopolymerization initiator in an amount of 0.5% by mole, both based on the said liquid crystal material, to obtain a polymerizable mixture. Using lecithin as the alignment film (an alignment film inducing homeotropic alignment), a cell was constructed (both substrates being glass substrates capable of transmitting visible light) as shown in Fig. 1. This polymerizable mixture was sealed at an isotropic phase temperature (the polymerizable mixture being in a liquid state) and then cooled down slowly to room temperature to prepare a sample having the liquid crystal molecules oriented to have homeotropic alignment. The sample was irradiated with 364 nm Ar ion laser at 4 W/cm² to induce a refractive index distribution (this also let advance fixation of the polymerizable mixture at the laser irradiated spot). The irradiation spot was shifted while continuing laser irradiation, and lastly one side of the sample was irradiated with 366 nm bright line of a high pressure mercury lamp at a light intensity of 5 W/cm² for 10 minutes to cause photopolymerization of the composition to thereby fix the whole of the composition to obtain an optical element 2. Thereafter, one of the substrates having an alignment film was separated to obtain a substrate having the optical element 2 and an alignment film (see FIG. 2). The surface of the optical element 2 was flat.

### (Production of light emitting device)

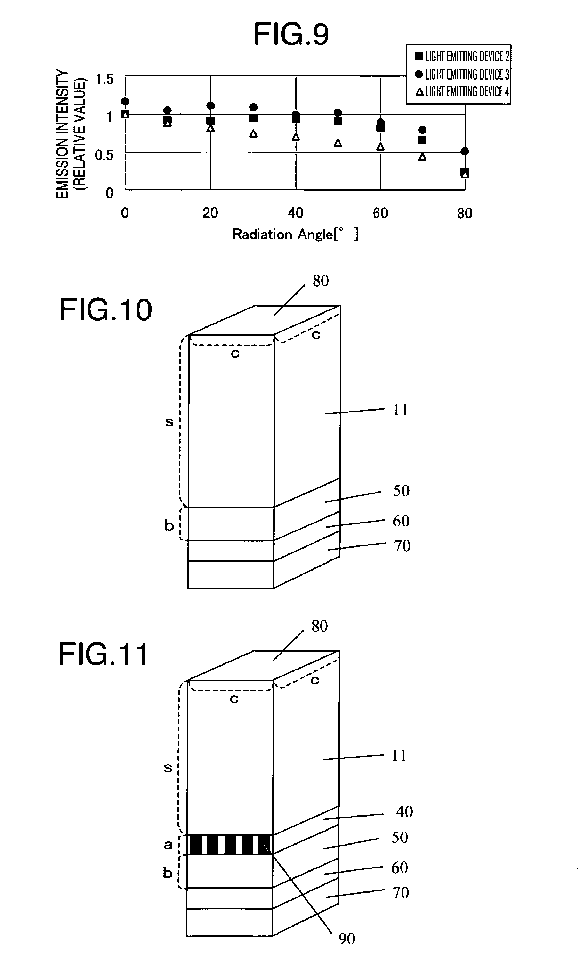

Using the above-described optical element 2, a light emitting device 2 such as illustrated in Fig. 7 was made and subjected to a photoluminescence (PL) evaluation. In the PL evaluation, rubrene-containing polymethyl methacrylate (PMMA) (rubrene contained in an amount of 5 mol% based on PMMA) was used as the light emitting layer. Using a PL evaluation system schematically shown in Fig. 8, the light emitting layer of the light emitting device 2 was irradiated with 488 nm Ar ion laser and the intensity of light emission (intensity at an emission wavelength of 550 nm) was measured. It could be confirmed (Fig. 9) that the intensity of light emission exceeded that obtainable with the light emitting device 4 of Comparative Example 1 described below. This indicates that it is possible to obtain an organic EL device with high outcoupling efficiency and high light emitting efficiency by producing an organic EL device in the manner shown in Fig. 4 using the optical element 2 and a light emitting layer composed of an organic EL material in lieu of rubrene-containing polymethyl methacrylate (PMMA).

### Example 4

### (Production of optical element)

The same procedure as defined in Example 3 was conducted except that the sample having its liquid crystal molecules oriented to have homeotropic alignment was irradiated with 364 nm Ar ion laser at 8 W/cm² to obtain an optical element 3. Then one of the substrates having an alignment film was separated to obtain a substrate having the optical element 3 and an alignment film (see Fig. 2). The surface of this optical element 3 was flat.

### (Production of light emitting device)

A light emitting device 3 such as illustrated in Fig. 7 was made by using the above-described optical element 3, and its PL evaluation was made. In the PL evaluation, rubrene-containing polymethyl methacrylate (PMMA) (rubrene contained in an amount of 5 mol% based on PMMA) was used as the light emitting layer. Using a PL evaluation system schematically shown in Fig. 8, the light emitting layer of the light emitting device 3 was irradiated with 488 nm Ar ion laser and the intensity of light emission (intensity at an emission wavelength of 550 nm) was measured. It could be confirmed (Fig. 9) that the intensity of light emission exceeded that obtainable with the light emitting device 4 of Comparative Example 1 described below. This indicates that it is possible to obtain an organic EL device with high outcoupling efficiency and high light emitting efficiency by producing an organic EL device in the manner shown in Fig. 4 using the optical element 2 and a light emitting layer composed of an organic EL material in lieu of rubrene-containing polymethyl methacrylate (PMMA).
In Fig. 8, ND designates a neutral density filter, WP a half-wavelength plate, and DEQ a depolarizer. The Ar ion laser (Ar⁺laser) was set at λ = 488 nm and 23 mW/cm².

### Comparative Example 1

### (Production of optical element)

The same procedure as defined in Example 3 was conducted except that the sample having homeotropic alignment of liquid crystal molecules was not irradiated with Ar ion laser but irradiated on one side with 366 nm bright line of a high pressure mercury lamp at a light intensity of 5 W/cm² for 10 minutes to obtain an optical element 4. Then one of the substrates having an alignment film was separated to obtain a substrate having the optical element 4 and an alignment film (see Fig. 2). The surface of the optical element 4 was flat.

### (Production of light emitting device)

Using the above-described optical element 4, a light emitting device 4 such as illustrated in Fig. 7 was formed, and its PL evaluation was made. In the PL evaluation, rubrene-containing polymethyl methacrylate (PMMA) (rubrene contained in an amount of 5 mol% based on PMMA) was used as the light emitting layer. Using a PL evaluation device schematically shown in Fig. 8, the light emitting layer of the light emitting device 3 was irradiated with 488 nm Ar ion laser and the emitted light intensity (intensity at an emission wavelength of 550 nm) was measured. It was found that the emitted light intensity was lower than that obtained when using the above-described light emitting device 2 or 3. This shows that an organic EL device with low outcoupling efficiency and low light emitting efficiency is produced even if it is made in the manner shown in Fig. 4 using the optical element 4 and a light emitting layer composed of an organic EL material in place of rubrene-containing polymethyl methacrylate (PUMA).

### Comparative Example 2

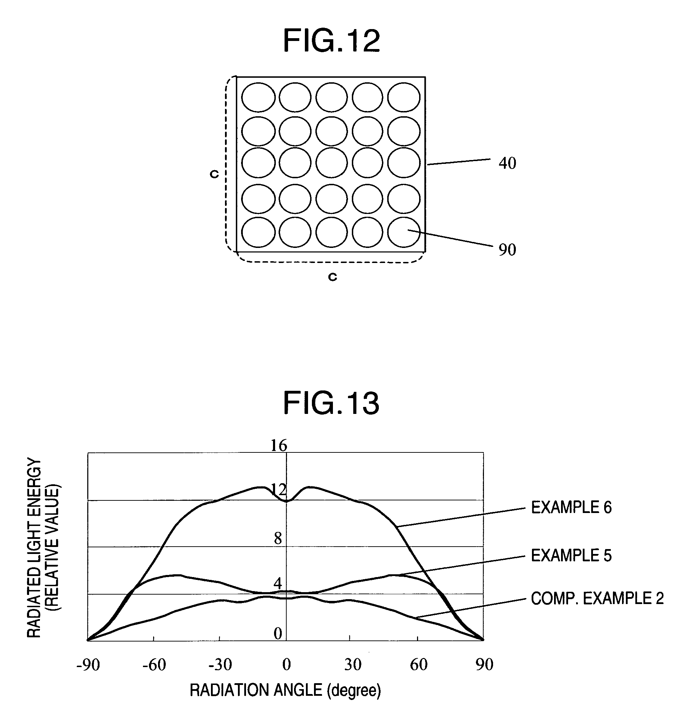

A rectangular parallelepipedic model illustrated in Fig. 10 was prepared as an organic EL device, and a ray tracing simulation was conducted on this model. Lamda Research Co.'s TrecePro (trade name) was used as a software application for this ray tracing simulation. In the model of Fig. 10, the light emitted from a light emitting layer 60 passes through an anode 50 and a substrate 11 and is radiated to the outside of the organic EL device from a light radiation area 80. It was assumed here that the light emitted from the light emitting layer 60 has a Lambertian distribution in the direction of radiation (satisfying the Lambert's cosine law). The number of the light rays entering the substrate 11 from the anode 50 was set at 200,000, and a perfect reflection surface was formed in the inside of the organic EL device, except for the light radiation area 80. The light which still remained in the inside of the organic EL device after 1,000 times of reflection was regarded as having vanished. The thickness (s) of the substrate 11 was set at 1,800 µm, the width (c) and depth (c) of the element at 600 µm and the thickness (b) of the anode at 200 µm. Also, the substrate and the anode were designed to have a refractive index of 1.5 and 2.0, respectively. The results of examination of radiation angle dependency of the energy of light radiated from the light radiation area in this simulation are shown in Fig. 13.

### Example 5

The ray tracing simulation of Comparative Example 2 was carried out by using a rectangular parallelepipedic model of Fig. 11 as an organic EL device in place of the model of Fig. 10 used in Comparative Example 2. In the organic EL device of Fig. 11, an optical element 40 is disposed between an anode 50 and a substrate 11. A top plan projection chart of the optical element 40 is shown in Fig. 12. There are provided the cylindrical refractive index distribution portions in the inside of the optical element 40. The refractive index distribution portions of the optical element 40 of Fig. 12 are so designed that the refractive index distribution will vary according to a curve of secondary degree toward the end of each distribution portion from its center, with the refractive index at the center being set at 1.7 and that at the end at 1.5. The refractive index of the parts other than the refractive index distribution portions of the optical element 40 was set at 1.5. There were also made the following settings: diameter of the refractive index distribution portions = 100 µm; shortest length of the gap between the adjoining refractive index distribution portions in the optical element 40 = 20 µm; shortest length of the gap between the side of the optical element and the refractive index distribution portions closest thereto = 10 µm; thickness (s) of the substrate 11 = 1,700 µm; thickness (s) of the optical element = 100 µm; width (c) and depth (c) of the element = 600 µm; thickness (b) of the anode = 200 µm; refractive index of the substrate = 1.5; refractive index of the anode = 2.0. The results of investigation of light radiation angle dependency of the energy of light radiated from the light radiation area according to the above simulation are shown in Fig. 13.

### Example 6

Ray tracing simulation was conducted in the same way as in Example 5 by using a rectangular parallelepipedic model of Fig. 11 as an organic EL device. The only difference of Example 6 from Example 5 is that, in Example 6, refractive index at the center of each refractive index distribution portion in the optical element 40 was made 2.0. The results of investigation of light radiation angle dependency of the energy of light radiated from the light radiation area according to this simulation are shown in Fig. 13.

According to Fig. 13, the integral value of the energy of radiated light at a radiation angle in the range of -90° through 90° is 1.7 in the case of Example 5 and 3.5 in the case of Example 6 when such an integral value in the case of Comparative Example 2 is assumed to be 1. This indicates that the organic EL device having an optical element provided with the refractive index distribution portions can radiate a greater volume of light energy than obtainable when such an optical element is absent. It was also found that this ray tracing simulation is very useful for more specifically designing and evaluating the structure of the organic EL device according to the present invention.

### Brief Description of the Drawings

[Fig. 1] illustrates a method for holding a polymerizable mixture between a pair of alignment films.
[Fig. 2] is a schematic illustration of the step (A2) in the present invention.
[Fig. 3] is a schematic illustration of the step (A3) in the present invention.
[Fig. 4] is a schematic illustration of the step (A4) in the present invention.
[Fig. 5] is a schematic illustration of the step (B3) in the present invention.
[Fig. 6] is a schematic illustration of the step (B4) in the present invention.
[Fig. 7] is a schematic illustration of a light emitting device.
[Fig. 8] is a schematic illustration of a system for evaluating emission of light from a light emitting device.
[Fig. 9] is a diagram showing the results of evaluation of emission of light from the light emitting devices.
[Fig. 10] is a schematic illustration of an organic EL device in a ray tracing simulation (Comparative Example 2).
[Fig. 11] is a schematic illustration of an organic EL device in a ray tracing simulation (Examples 5 and 6).
[Fig. 12] is a schema (a top plan projection chart) of an optical element in Examples 5 and 6.
[Fig. 13] is a diagram showing the results of investigation of light radiation angle dependency of the radiated light energy.

### Description of Reference Numerals

10: substrate 1 having an alignment film
11: substrate 1 (substrate capable of transmitting visible light)
12: alignment film
20: substrate 2 having an alignment film
21: substrate 2
22: alignment film
30: spacer (sealer) arranged like a frame
40: liquid crystal molecules-fixed layer (optical element)
50: anode
60: light emitting layer
70: cathode
80: light radiation area
90: refractive index distribution portion

## Claims

1. An organic EL device comprising:
a layered optical element which contains at least a liquid crystal material and a dye and has a refractive index distribution based on orientation of liquid crystal molecules constituting the liquid crystal material, wherein said refractive index distribution is fixed;
a substrate which can transmit visible light;
a light emitting layer comprising an organic EL material;
a cathode; and
an anode.

2. The organic EL device according to claim 1 wherein both of the cathode and the anode are layered.

3. The organic EL device according to claim 2 which further comprises an alignment film which is contacted with the optical element.

4. The organic EL device according to claim 3 wherein the layered anode is contacted with the optical element.

5. A method for producing an organic EL device comprising the following steps (A1), (A2), (A3) and (A4) in this order:
(A1) using two substrates each having an alignment film (wherein at least one of the substrates is capable of transmitting visible light), arranging the two substrates so that their respective alignment films face each other, disposing a polymerizable mixture containing a liquid crystal material and a dye between the opposing alignment films, irradiating the polymerizable mixture with light to orient a liquid crystal molecule in the liquid crystal material, and further polymerizing said polymerizable mixture for fixing it to obtain a liquid crystal molecule-fixed layer (optical element);
(A2) separating one of the substrates having an alignment film to obtain a substrate having the optical element and the alignment film (wherein said substrate is one capable of transmitting visible light);
(A3) forming a layered anode on an optical element side of the substrate having the optical element and the alignment film; and
(A4) forming a light emitting layer comprising an organic EL material and a layered cathode in this order on a layered anode side of the substrate.

6. The organic EL device according to claim 3 wherein the layered anode is contacted with the substrate capable of transmitting visible light.

7. A method for producing an organic EL device comprising the following steps (B1), (B2), (B3) and (B4) in this order:
(B1) using two substrates each having an alignment film (wherein at least one of the substrates is capable of transmitting visible light), arranging the two substrates so that their respective alignment films face each other, disposing a polymerizable mixture containing a liquid crystal material and a dye between the opposing alignment films, irradiating the polymerizable mixture with light to orient a liquid crystal molecule in the liquid crystal material, and further polymerizing said polymerizable mixture for fixing it to obtain a liquid crystal molecule-fixed layer (optical element);
(B2) separating one of the substrates having an alignment film to obtain a substrate having the optical element and the alignment film (wherein said substrate is one capable of transmitting visible light);
(B3) forming a layered anode on a bare side of the substrate having the optical element and the alignment film; and
(B4) forming a light emitting layer comprising an organic EL material and a layered cathode in this order on a layered anode of the substrate.

8. A method for evaluating an organic EL device comprising the step of: using a ray tracing simulation in designing a structure of the organic EL device according to claim 1, 2, 3, 4 or 6.
